# FASCICULE DE BREVET EUROPEEN

(11) **EP 0 407 260 B1**
(45) Date de publication et mention de la délivrance du brevet: **15.09.1993**
(21) Numéro de dépôt: 90401806.6
(22) Date de dépôt: 25.06.1990
(51) Int. Cl.: H04B 7/005, H03G 3/20

(54) **Dispositif d'adaptation de gain en réception de signaux de radio communication**
Einrichtung zur Verstärkungsanpassung beim Empfangen von Radionachrichtensignalen
Gain matching apparatus for the reception of radio communication signals

(30) Priorité: 27.06.1989 FR 8908530
(43) Date de publication de la demande: 09.01.1991
(73) Titulaire: MATRA COMMUNICATION, 29101 Quimper (FR)
(72) Inventeur: Alard, Michel, F-75014 Paris (FR); Zaccone, Pierre, F-92370 Chaville (FR)
(74) Mandataire: Fruchard, Guy

(56) Documents cités:
- EP-A- 0 099 637
- FR-A- 2 441 956

## Description

La présente invention concerne un dispositif de réception de signaux de radio communication, et plus particulièrement bien que non exclusivement un dispositif de réception pour une station d'un réseau de radio téléphonie.

On connaît des dispositifs de radio communication, en particulier des dispositifs de radio communication à multiplexage dans le temps dans lesquels les signaux à transmettre sont organisés sous forme de paquets transmis successivement sur un canal radio. Les dispositifs de réception de tels signaux comportent généralement une antenne réceptrice, un organe de préamplification à gain variable relié à l'antenne réceptrice, un organe de filtrage relié à l'organe de préamplification, un organe d'amplification à gain variable relié à la sortie de l'organe de filtrage, un organe de conversion analogique - numérique ayant une entrée reliée à l'organe d'amplification et une sortie reliée à un organe d'analyse des signaux convertis et à une unité de traitement numérique, l'organe d'analyse des signaux convertis étant lui-même relié à un organe de commande de gain ayant une sortie reliée à l'organe de préamplification et à l'organe d'amplification. L'organe de commande de gain sert à adapter le gain des organes de préamplification et d'amplification à la puissance du signal reçu. En effet, si le signal reçu est insuffisamment amplifié, le signal converti n'a pas une énergie suffisante pour être convenablement traité par l'unité de traitement numérique, tandis que si le signal reçu est trop fortement amplifié il est écrété par l'organe de conversion qui ne peut plus remplir son rôle. Pour que la chaîne de commande de gain puisse fonctionner convenablement, il faut disposer dans la transmission d'un nombre suffisant de bits permettant la mesure du niveau reçu et la correction automatique du gain.

Ainsi, lorsque des bits significatifs atteignent la chaîne d'amplification, le gain est convenablement adapté à la puissance du signal et un traitement correct de ce signal est assuré par l'unité de traitement numérique.

Bien que les temps de réaction des chaînes de commande automatique de gain soient très courts, ces chaînes de commande ne sont pas adaptées à la réception de signaux dans lesquels on ne dispose pas d'un nombre suffisant de bits pouvant être perdus pendant le processus de mesure et de correction automatique du gain. Dans ce cas, le gain risque donc d'être mal adapté et d'entraîner la perte de données.

Un but de la présente invention est de proposer un dispositif de réception de signaux de radio communication adapté au traitement de signaux pour lesquels on ne dispose pas d'un temps suffisant pour procéder à une correction de gain.

En vue de la réalisation de ce but, on prévoit selon l'invention un dispositif de réception de signaux de radio communication comprenant une antenne réceptrice, un organe de préamplification et de filtrage relié à l'antenne réceptrice, un organe d'amplification relié à sa sortie de l'organe de préamplification et de filtrage, un organe de conversion analogique - numérique relié à la sortie de l'organe d'amplification, et une unité de traitement numérique reliée à l'organe de conversion, dans lequel l'organe d'amplification comporte des éléments d'amplification à gain fixe montés en parallèle, et, entre l'organe de conversion et l'unité de traitement numérique, le dispositif comporte des moyens de mise en mémoire de signaux à différents niveaux de gain, des moyens pour relire ces signaux, sélectionner un niveau de gain adapté à l'unité de traitement numérique, et transmettre des signaux mémorisés à ce niveau de gain.

Ainsi, un signal reçu est mémorisé simultanément à différents niveaux d'amplification de sorte que la lecture de la mémoire, la sélection parmi les signaux mémorisés de celui qui correspond au niveau d'amplification le plus approprié et la transmission de ce signal à l'unité de traitement numérique sont effectués après la réception en disposant d'un temps de traitement relativement important. On remarquera en outre que le signal au niveau d'amplification le plus approprié est sélectionné pour chaque paquet reçu. Le dispositif selon l'invention assure donc une transmission à l'unité de traitement numérique de chaque paquet reçu à un niveau sensiblement constant même si le niveau de puissance du signal reçu sur l'antenne réceptrice varie dans le temps alors que les dispositifs à commande automatique de gain ne peuvent s'adapter que progressivement à de telles variations.

Selon une version avantageuse de l'invention, le dispositif de réception comporte un organe de conversion commun à plusieurs éléments d'amplification, cet organe de conversion commun étant relié aux éléments d'amplification associés par un organe de connexion commandée pour établir cycliquement une connexion entre un élément d'amplification et l'organe de conversion commun.

Ainsi, avec un même organe de conversion, on assure un échantillonnage du signal reçu à différents niveaux d'amplification.

Selon un mode de réalisation préféré de l'invention, l'organe d'amplification comporte plusieurs étages d'amplification en série dans chacun desquels des éléments d'amplification sont montés en parallèle selon une structure générale pyramidale.

Ainsi, on obtient une qualité d'amplification élevée en limitant le gain d'amplification de chaque étage.

D'autres caractéristiques et avantages de l'invention apparaîtront à la lecture de la description qui suit d'un mode de réalisation particulier non limitatif de l'invention en liaison avec les dessins ci-joints parmi lesquels :
- la figure 1 est un diagramme par blocs d'un mode de réalisation du dispositif selon l'invention,
- la figure 2 est un diagramme par blocs plus détaillé d'une partie du dispositif de la figure 1.

En référence aux figures, le dispositif de réception de signaux de radio communication selon l'invention comporte une antenne réceptrice 1 reliée à un organe de préamplification et de filtrage 2.

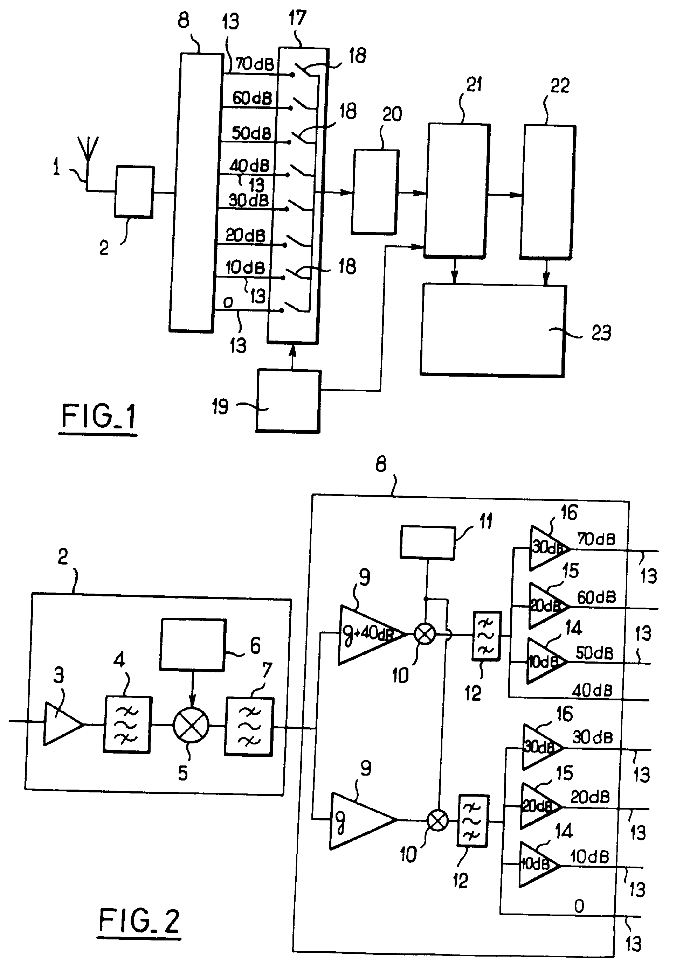

Ainsi qu'on peut le voir sur la figure 2, l'organe de préamplification et de filtrage comporte un élément de préamplification à gain fixe 3 dont la sortie est reliée à un filtre de bande 4. La sortie du filtre de bande 4 est reliée à une entrée d'un mélangeur 5 ayant une autre entrée reliée à un oscillateur local 6. Un filtre 7 centré sur la fréquence de l'oscillateur local 6 et ayant une largeur de bande égale à celle du signal que l'on souhaite traiter est reliée à la sortie du mélangeur 5.

La sortie de l'organe de préamplification et de filtrage 2 est reliée à un organe d'amplification 8 comportant (voir figure 2) un premier étage d'amplification comprenant deux amplificateurs à gain fixe montés en parallèle. Dans le mode de réalisation illustré, l'un des amplificateurs 9 a un gain g adapté au signal le plus puissant que l'on envisage de recevoir au niveau de l'installation tandis que l'autre amplificateur 9 a un gain g plus 40 dB. Les amplificateurs 9 sont suivis de mélangeurs 10 ayant une première entrée reliée à l'un des amplificateurs 9 et une seconde entrée reliée à un oscillateur local 11 dont la fonction est d'effectuer une transposition de fréquence pour centrer le signal sur la fréquence Fb/2 où Fb est la fréquence bit du signal. Les mélangeurs 10 sont suivis par un élément de filtrage 12 destiné à éliminer les résidus. La sortie de chaque mélangeur 12 est reliée en parallèle à quatre lignes de sorties 13. Pour chaque groupe de lignes de sortie 13, l'une des lignes ne comporte aucun amplificateur, une seconde ligne comporte un amplificateur 14 ayant un gain de 10 dB, une troisième ligne comporte un amplificateur 15 ayant un gain de 20dB et la quatrième ligne comporte un amplificateur 16 ayant un gain de 30dB, lesquelles constituent un second étage d'amplification de l'organe d'amplification 8. Ainsi, les lignes de sortie 13 ont des niveaux d'amplification qui s'échelonnent entre 0 et 70dB d'amplification par rapport au signal d'entrée dans l'organe d'amplification 8.

Les lignes de sortie 13 de l'organe d'amplification 8 sont reliées à l'entrée d'un échantillonneur 17 comportant une série de moyens de connexion 18 montés en parallèle et commandés par un organe de commande 19 pour établir cycliquement une connexion entre l'une des lignes 13 et un organe de conversion analogique-numérique commun 20. Dans l'exemple de réalisation décrit où l'organe de conversion est commun à tous les niveaux d'amplification, la fréquence d'échantillonnage sera de 2 Fb pour chaque ligne 13 c'est à dire de 16 Fb pour l'échantillonneur afin d'obtenir un échantillonnage significatif des signaux reçus.

La sortie de l'organe de conversion 20 est reliée à une entrée de moyens de mise en mémoire 21 dont une autre entrée est reliée à l'organe de commande 19 afin d'affecter à chaque échantillon reçu de l'organe de conversion 20 une adresse en correspondance avec la ligne 13 associée à l'échantillon mémorisé. Les moyens de mise en mémoire 21 sont reliés à des moyens de sélection de signaux mémorisés 22 qui effectuent une lecture de l'ensemble des échantillons d'un paquet mémorisé pour chaque niveau d'amplification et une sélection du niveau d'amplification le mieux adapté en fonction de critères introduits au niveau des moyens de sélection, par exemple le niveau moyen d'énergie ou le nombre d'écrétages.

Par ailleurs, les moyens de mise en mémoire 21 et les moyens de sélection de signaux mémorisés 22 sont reliés à une unité de traitement numérique 23 de sorte qu'après avoir déterminé le niveau d'amplification le plus adapté au paquet qui vient d'être reçu, les moyens de sélection de signaux mémorisés transmettent à l'unité de traitement numérique l'information sur ce niveau d'amplification et provoquent simultanément le transfert depuis les moyens de mise en mémoire 21 vers l'unité de traitement numérique 23 de l'ensemble des échantillons recueillis à ce niveau d'amplification.

On remarquera que pour chaque paquet, la sélection du niveau d'amplification est effectuée après mémorisation de l'ensemble des bits d'un paquet. La sélection est donc effectuée non seulement sur les bits non significatifs d'un paquet, mais également sur les bits significatifs de sorte qu la sélection est d'une très grande qualité. De plus, étant effectuée sur chaque paquet reçu, la sélection est particulièrement adaptée même lorsque le niveau du signal reçu varie de façon importante d'un paquet à un autre.

Bien entendu l'invention n'est pas limitée au mode de réalisation décrit et on peut y apporter des variantes de réalisation sans sortir du cadre de l'invention. En particulier, bien que l'invention ait été décrite avec un organe d'amplification 8 comportant huit lignes de sortie échelonnées de 10 dB en 10 dB, le nombre de niveaux d'amplification sera adapté pour chaque installation à la plage des niveaux auxquels un signal doit être reçu.

Bien que le dispositif de réception selon l'invention ait été décrit avec un organe de conversion commun associé à un organe d'échantillonnage, on peut également prévoir d'équiper chaque niveau d'amplification d'un convertisseur individuel. ou de combiner plusieurs convertisseurs chacun associé à plusieurs lignes d'amplification.

Par ailleurs, bien qu'au niveau de l'organe d'amplification 8 on ait prévu une amplification de l'ensemble du signal centré à Fb/2, on peut également prévoir de décomposer le signal reçu en composantes I et Q au moyen d'un dispositif déphaseur, le nombre d'éléments d'amplification du second étage d'amplification étant alors doublé tandis que la fréquence d'échantillonnage sur chaque ligne 13 est divisée par deux par rapport au mode de réalisation illustré.

## Revendications

1. Dispositif de réception de signaux de radio communication comprenant une antenne réceptrice (1), un organe de préamplification et de filtrage (2) relié à l'antenne réceptrice, un organe d'amplification (8) relié à la sortie de l'organe de préamplification et de filtrage, un organe de conversion analogique - numérique (20) relié à la sortie de l'organe d'amplification, et une unité de traitement numérique (23) reliée à l'organe de conversion (20) caractérisé en ce que l'organe d'amplification (8) comporte des éléments d'amplification à gain fixe (9; 14,15,16) montés en parallèle et en ce qu'entre l'organe de conversion (20) et l'unité de traitement numérique (23), le dispositif comporte des moyens de mise en mémoire (21) de signaux numérisés à différents niveaux de gain, des moyens (22) pour relire ces signaux, sélectionner un niveau de gain adapté à l'unité de traitement numérique (23), et transmettre des signaux mémorisés à ce niveau de gain.

2. Dispositif de réception des signaux de radio communication selon la revendication 1 caractérisé en ce qu'il comporte un organe de conversion (20) commun à plusieurs éléments d'amplification, cet organe de conversion commun étant relié aux éléments d'amplification associés par un organe de connexion (17) commandé pour établir cycliquement une connexion entre un élément d'amplification et l'organe de conversion commun (20).

3. Dispositif de réception de signaux de radio communication selon la revendication 1 ou la revendication 2, caractérisé en ce que l'organe d'amplification (8) comporte plusieurs étages d'amplification en séries dans chacun desquels des éléments d'amplification (9 ; 13,14,15) sont montés en parallèle selon une structure générale pyramidale.

## Patentansprüche

1. Vorrichtung zum Empfang von Funkverkehrssignalen umfassend eine Empfangsantenne (1), ein mit der Empfangsantenne verbundenes Vorverstärkungs- und Filterorgan (2), einen mit dem Ausgang des Vorverstärkungs- und Filterorganes verbundenen Verstärker (8), einen mit dem Ausgang des Verstärkers verbundenen Analog/Digital-Wandler (20) und eine mit dem Wandler (20) verbundene Recheneinheit (23), dadurch **gekennzeichnet**, daß der Verstärker (8) parallel geschaltete Verstärkungselemente (9; 14, 15, 16) mit fester Verstärkung umfaßt und daß die Vorrichtung zwischen dem Wandler (20) und der Recheneinheit (23) Speichermittel (21) zum Speichern von digitalen Signalen mit unterschiedlichem Verstärkungspegel und Mittel (22) zum Lesen dieser Signale, zum Auswählen eines für die Recheneinheit (23) geeigneten Verstärkungspegels und zum Übertragen der gespeicherten Signale mit diesem Verstärkungspegel umfaßt.

2. Vorrichtung zum Empfang von Funkverkehrssignalen nach Anspruch 1, dadurch **gekennzeichnet**, daß sie einen gemeinsamen Wandler (20) für mehrere Verstärkungselemente hat, wobei dieser gemeinsame Wandler mit den zugehörigen Verstärkungselementen über ein Verbindungsorgan (17) verbunden ist, das gesteuert ist, um zyklisch eine Verbindung zwischen einem Verstärkungselement und dem gemeinsamen Wandler (20) herzustellen.

3. Vorrichtung zum Empfang von Funkverkehrssignalen nach Anspruch 1 oder 2, dadurch **gekennzeichnet**, daß der Verstärker mehrere in Reihe geschaltete Verstärkungsstufen umfaßt, in denen jeweils Verstärkungselemente (9; 13, 14, 15) parallel zueinander in einer im wesentlichen pyramidenartigen Struktur angeordnet sind.

## Claims

1. Receiver apparatus for receiving radiocommunication signals, the apparatus comprising a receive antenna (1), a preamplifier and filter member (2) connected to the receive antenna, an amplifier member (8) connected to the output from the preamplifer and filter member, an analog-to-digital converter member (8) connected to the output from the amplifier member, and a digital processor unit (23) connected to the converter member (20), the apparatus being characterized in that the amplifier member (8) includes fixed gain amplifiers (9; 14, 15, 16) connected in parallel, and in that, between the converter member (20) and the digital processor unit (23) the apparatus includes storage means (21) for storing digitalized signals at different levels of gain, and means (22) for reading these signals, for selecting a level of gain which is adapted to the digital processor unit (23), and for transmitting the signals stored at said level of gain.

2. Receiver apparatus for radiocommunication signals according to claim 1, characterized in that it includes a converter member (20) common to a plurality of amplifiers, said common converter member being connected to the associated amplifiers via a connection member (17) which is controlled to establish connections cyclically between the common converter member (20) and respective ones of the amplifiers.

3. Receiver apparatus for radiocommunication signals according to claim 1 or claim 2, characterized in that the amplifier member (8) includes a plurality of amplification stages in series, each comprising amplifiers (9; 13, 14, 15) connected in parallel in a generally pyramid-shaped structure.
